# EUROPEAN PATENT SPECIFICATION

(11) **EP 2 928 021 B1**
(45) Date of publication and mention of the grant of the patent: **22.11.2017**
(21) Application number: 15166971.0
(22) Date of filing: 02.07.2008
(51) Int. Cl.: H01Q 23/00, B65D 75/12, G06K 19/077, H01Q 1/36, H01Q 7/00, H04B 5/02, H01Q 1/22, H01Q 1/44

(54) **PRINTED WIRING SUBSTRATE**
DRAHTLOSE IC-VORRICHTUNG UND KOMPONENTE FÜR DRAHTLOSE IC-VORRICHTUNG
DISPOSITIF CI SANS FIL ET COMPOSANT POUR LE DISPOSITIF CI SANS FIL

(30) Priority: 04.07.2007 JP 2007176360; 19.09.2007 JP 2007241819; 31.01.2008 WO PCT/JP2008/051521; 14.04.2008 JP 2008105188
(43) Date of publication of application: 07.10.2015
(62) Divisional of application: 08777756.1
(73) Proprietor: MURATA MANUFACTURING CO., LTD., Nagaokakyo-shi, Kyoto 617-8555 (JP)
(72) Inventor: Kato, Noboru, Nagaokakyo-shi, Kyoto 617-8555 (JP); Ikemoto, Nobuo, Nagaokakyo-shi, Kyoto 617-8555 (JP)
(74) Representative: Stöckeler, Ferdinand

(56) References cited:
- EP-A1- 1 772 927
- EP-A1- 2 141 769
- JP-A- 2005 079 832
- US-A1- 2003 020 568
- US-A1- 2005 179 604
- US-A1- 2007 018 893

## Description

### Technical Field

The present invention relates to a wireless IC device used for a radio frequency identification (RFID) system that performs data communication in a noncontact manner through electromagnetic waves, and a component for the wireless IC device.

### Background Art

In recent years, an article management system has been using an RFID system which includes a reader/writer that generates an induction field and a wireless IC device that stores predetermined information allocated to an article, and noncontact communication is established between the reader/writer and the wireless IC device to transmit the information therebetween.

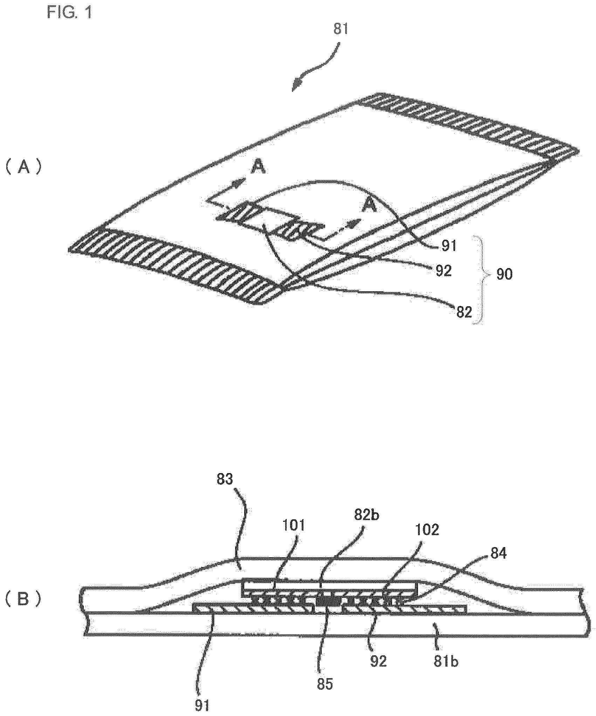

FIG. 1 are a views that show an example of a noncontact IC tag (wireless IC device) in which an IC tag label is attached to an IC tag antenna, which is described in Patent Document 1. FIG. 1(A) is a plan view. FIG. 1(B) is an enlarged cross-sectional view taken along the line A-A in FIG. 1(A). The noncontact IC tag antenna is formed of two separated antenna patterns 91 and 92. The antenna patterns 91 and 92 each are formed of a layer of metal thin films.

Antennas 101 and 102 are formed on a label base material 82b of the noncontact IC tag label 82, and an IC chip 85 is mounted thereon. The antennas 101 and 102 of the noncontact IC tag label 82 are attached to be in contact with the antenna patterns 91 and 92 via an anisotropic conductive adhesive 84 to thereby form a noncontact IC tag 90.

A sealant film 83 is laminated on the label base material 82b to prevent peeling of the IC tag label, and finally an IC tag attached package 81 is formed.
Patent Document 1: Japanese Unexamined Patent Application Publication No. 2003-243918

EP 1 772 927 A1 discloses an antenna unit having a antenna. A T-shaped cutout portion is formed in the antenna and the periphery of the cutout portion forms an impedance matching wiring portion. Connecting regions of the antenna, which are left and right of the cutout portion, are connected to connecting ends of an IC module comprising an IC chip. The IC chip may be connected directly to the antenna.

US 2007/018893 A1 discloses an antenna comprising a dielectric member, an antenna pattern formed on one surface of the dielectric member, and a ground pattern formed on the other surface of the dielectric member. A part or the whole of the antenna is implanted in a dielectric layer on the side from which a laser beam does not come in of an optical recording medium symmetrically having a metal layer reflecting the laser beam and the dielectric layer.

US 2005/0179604 A1 discloses an antenna including a plurality of discrete loop antennas disposed concentrically on a substrate. Each one of said plurality of loop antennas is electrically isolated from each other one of said plurality of loop antennas.

### Disclosure of Invention

### Problems to be Solved by the Invention

The noncontact IC tag of Patent Document 1 and the package provided with the noncontact IC tag have the following problems.
(a) Because antenna patterns are formed in a process different from the process in which a package is formed, a process of producing an antenna is required. This causes the process to be prolonged and requires an additional member to thereby increase production costs for the package.
(b) To obtain a sufficient radiation characteristic, it is necessary to increase the size of the antenna pattern, and, therefore, it is difficult to attach a tag to a small article.
(c) Because a tag is formed on the base material of an article and another film covers the formation face of the tag, the thickness of the IC tag formation portion increases.

Then, it is an object of the invention to provide a wireless IC device that eliminates the above problems, reduces production costs for a package, enables attachment to a small article, and suppresses the thickness of the tag formation portion.

### Means for Solving the Problems

To solve the above problems, the present invention provides a wireless IC device according to claim 1.

Further developments of the invention are defined in the dependent claims.

### Advantages

According to the invention, the following advantageous effects are obtained. For example, processes or members for forming an antenna pattern shown in FIG. 1 on an article are unnecessary. Thus, there is almost no increase in cost for providing a wireless IC device for an article.

In addition, because the entire or portion of the article may be utilized as a radiator, a sufficient radiation characteristic may be obtained even when it is attached to a small article.

Furthermore, because the thickness of a portion on a base material of the article, at which the high-frequency device is provided, may be reduced, a protrusion of the high-frequency device portion may be suppressed and, therefore, an appearance is not influenced.

Moreover, by using the electromagnetic coupling module, impedance matching between the wireless IC chip and the radiation electrode may be designed within the power supply circuit substrate. Thus, it is not necessary to limit the shape or material of the radiation electrode, and it may be applied to any articles.

### Brief Description of Drawings

[FIG. 1] FIG. 1 is a view that shows the configuration of a wireless IC device described in Patent Document 1.
[FIG. 2] FIG. 2 is a view that shows the configuration of a wireless IC device according to a first comparative example and the configuration of an article provided with the wireless IC device.
[FIG. 3] FIG. 3 is a configuration diagram of the wireless IC device, showing only a relevant portion of the article shown in FIG. 2.
[FIG. 4] FIG. 4 is a view that shows the configuration of a wireless IC device according to a second comparative example and the configuration of an article provided with the wireless IC device.
[FIG. 5] FIG. 5 is a configuration diagram of the wireless IC device, showing only a relevant portion of the article shown in FIG. 3.
[FIG. 6] FIG. 6 is a view that shows the configuration of a wireless IC device according to a third comparative example and the configuration of an article provided with the wireless IC device.
[FIG. 7] FIG. 7 is a view that shows the configuration of a wireless IC device according to a fourth comparative example and the configuration of an article provided with the wireless IC device.
[FIG. 8] FIG. 8 is a center cross-sectional view that is taken along the line passing a main portion of the wireless IC device and a partially enlarged plan view of the main portion of the wireless IC device.
[FIG. 9] FIG. 9 is a view that shows the configuration of a wireless IC device according to a fifth comparative example.
[FIG. 10] FIG. 10 is an external perspective view of an electromagnetic coupling module 1 used for a wireless IC device according to a sixth comparative example.
[FIG. 11] FIG. 11 is an exploded view of the internal configuration of a power supply circuit substrate of an electromagnetic coupling module.
[FIG. 12] FIG. 12 is an equivalent circuit diagram that includes the power supply circuit substrate and a cutout portion of a metal film.
[FIG. 13] FIG. 13 is a view that shows the configuration of a wireless IC device according to a seventh comparative example and the configuration of an article provided with the wireless IC device.
[FIG. 14] FIG. 14 is a cross-sectional view of a main portion of the wireless IC device.
[FIG. 15] FIG. 15 is an exploded perspective view of a power supply circuit substrate of a wireless IC device according to an eighth comparative example.
[FIG. 16] FIG. 16 is an equivalent circuit diagram of a main portion of the wireless IC device.
[FIG. 17] FIG. 17 is a plan view of an electromagnetic coupling module used for a wireless IC device according to a ninth comparative example.
[FIG. 18] FIG. 18 is a view that shows the configuration of a wireless IC device according to a first embodiment.
[FIG. 19] FIG. 19 is a view that shows some configurations of a wireless IC devices according to an second embodiment.
[FIG. 20] FIG. 20 is a view that shows the configuration of another wireless IC device according to the second embodiment.
[FIG. 21] FIG. 21 is a view that shows some configurations of further another wireless IC device according to the second embodiment.
[FIG. 22] FIG. 22 is a view that shows the configuration of a wireless IC device according to a third embodiment.
[FIG. 23] FIG. 23 is a view that shows some configurations of a wireless IC device according to a fourth embodiment.
[FIG. 24] FIG. 24 is a plan view that shows the configuration of a wireless IC device according to a fifth embodiment.
[FIG. 25] FIG. 25 is a plan view that shows the configuration of a wireless IC device according to a sixth embodiment.
[FIG. 26] FIG. 26 is a plan view that shows the configuration of a wireless IC device according to a seventh embodiment.
[FIG. 27] FIG. 27 is a perspective view of a cellular phone terminal provided with a wireless IC device according to an eighth embodiment and a cross-sectional view of a main portion of an internal circuit substrate.
[FIG. 28] FIG. 28 is a plan view that shows the configuration of a component for a wireless IC device according to a ninth embodiment.
[FIG. 29] FIG. 29 is a plan view that shows a wireless IC device that uses the component for a wireless IC device according to the ninth embodiment.
[FIG. 30] FIG. 30 is a view that shows an example in which a main portion of a wireless IC device is formed within a ground electrode formation area on a printed wiring substrate 80.
[FIG. 31] FIG. 31 is a plan view that shows the configuration of a component for a wireless IC device according to a tenth embodiment and the configuration of a wireless IC device provided with that component.
[FIG. 32] FIG. 32 is a plan view that shows the configuration of a component for a wireless IC device according to an eleventh embodiment.
[FIG. 33] FIG. 33 is a plan view that shows the configuration of a wireless IC device provided with the component for a wireless IC device according to the eleventh embodiment.
[FIG. 34] FIG. 34 is a plan view that shows the configuration of a component 113 for a wireless IC device according to a twelfth embodiment.

### Reference Numerals

- 1, 2, 3: electromagnetic coupling module
- 4: power supply circuit substrate
- 5: wireless IC chip
- 6: main portion of wireless IC device
- 7: loop electrode
- 8: radiation electrode
- 10: base material
- 11: substrate
- 12: loop electrode
- 13: printed wiring substrate
- 15: circuit substrate
- 16: electrode pattern
- 17, 18: electronic component
- 20: inductor electrode
- 21: molded resin
- 25: capacitor electrode
- 30: loop electrode
- 35a to 35d: wireless IC chip mounting land
- 40: power supply circuit substrate
- 41A to 41H: dielectric layer
- 42a: via hole
- 45a, 45b: inductor electrode
- 46, 47: inductor electrode
- 51: capacitor electrode
- 53 to 57: capacitor electrode
- 60: article package
- 61: cutout portion
- 62: non-conductive portion
- 63: metal plane body
- 64: insulative sheet
- 65: metal film
- 66: cutout portion
- 67: matching circuit
- 68: resonant conductor
- 69: metal film (ground conductor)
- 70 to 73: article
- 80: printed wiring substrate
- 81: mounted side conductor component (resonant conductor)
- 82: process line installed conductor (resonant conductor)
- 111, 112, 113: component for wireless IC device
- C1: capacitor
- C2: capacitor
- L1, L2: inductor
- E: electric field
- H: magnetic field

### Best Modes for Carrying Out the Invention

### First Comparative Example

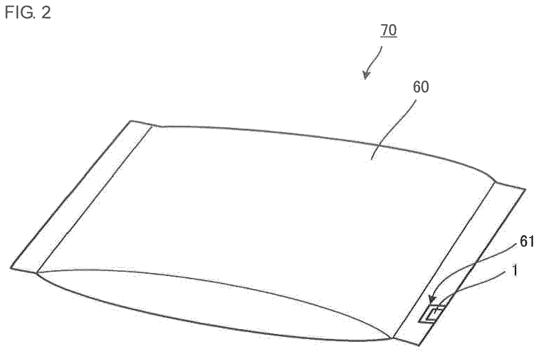

FIG. 2 is an external perspective view that shows the configuration of a wireless IC device according to a first comparative example and the configuration of an article provided with the wireless IC device. The article 70 is, for example, a packed snack, such as a packed potato chips. An article package 60 is a package that is formed so that an aluminum-deposited laminated film is formed into a bag-like shape.

A cutout portion (portion at which aluminum is not vapor-deposited) 61 is formed at an edge portion of the article package 60, and an electromagnetic coupling module 1 is arranged in the cutout portion 61.

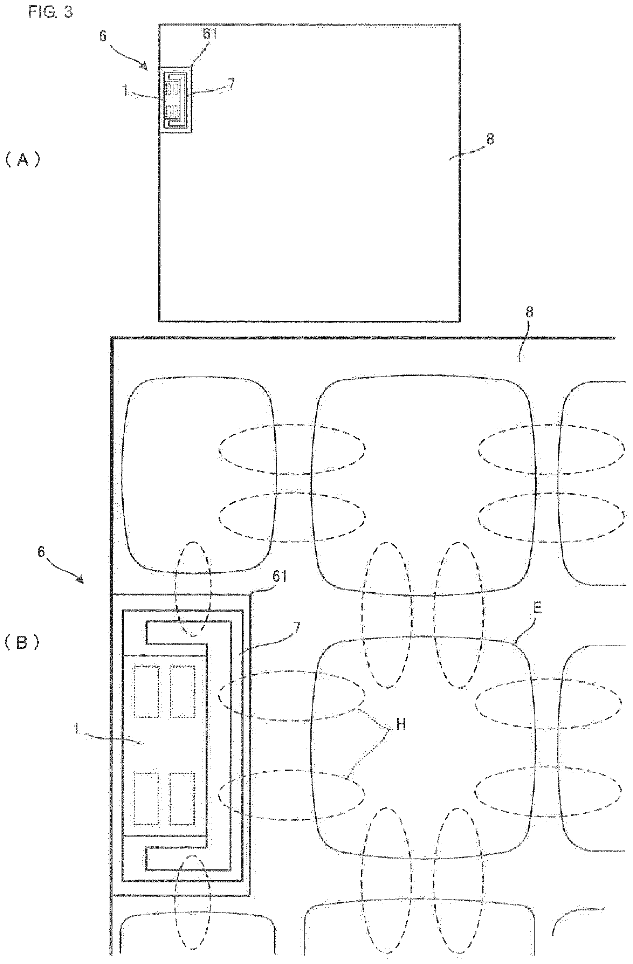

FIG. 3 is a view that shows the configuration of a wireless IC device and shows only a relevant portion of the article 70 shown in FIG. 2. In FIG. 3, a radiation electrode 8 corresponds to an aluminum-deposited layer of the aluminum-deposited laminated film of the article package 60 shown in FIG. 2. The cutout portion (electrode non-formation portion) 61 of the radiation electrode 8 forms a loop electrode 7 inside, and the electromagnetic coupling module 1 is mounted at the cutout portion 61 so as to be coupled to the loop electrode 7. The loop electrode 7 is patterned when aluminum deposition of the aluminum-deposited laminated film is performed. Alternatively, a conductive pattern may be formed by printing in a process different from the process of aluminum deposition.

FIG. 3(B) schematically shows an example of a distribution of electromagnetic field that is generated in the radiation electrode 8 when the loop electrode 7 is applied as a transmission auxiliary radiator. In the drawing, the broken line represents the loop of a magnetic field H, and the solid line represents the loop of an electric field E. The loop electrode 7 is applied as a magnetic field transmission auxiliary radiator. The magnetic field H generated by the loop electrode 7 perpendicularly intersects with the radiation electrode 8 to induce the electric field E. The electric field loop induces a magnetic field loop, and the chain of that action extends a distribution of electromagnetic field.

The above example is described using the loop electrode 7 as a transmission auxiliary radiator. When the loop electrode 7 is applied as a reception auxiliary radiator as well, a similar action may be attained to obtain a high gain.

In this way, when the article includes a conductive portion having a predetermined area and the conductive portion acts as a radiator, and when a large number of the articles are overlapped, chain induction of the electric field and magnetic field propagates among articles. Thus, even when a large number of articles are overlapped (if anything, overlapped), the wireless IC device operates to attain a high gain. For example, in a state where the antenna of a reader/writer is brought close to a portion of a pile of packed potato chips, IDs of all of the pile of packed potato chips may be read.

Note that the electromagnetic coupling module 1 shown in FIG. 3 includes a wireless IC chip, which will be described later, and a power supply circuit substrate that is connected to the wireless IC chip and that is coupled to an external circuit (in this example, the loop electrode 7, and the radiation electrode 8 via the loop electrode 7). The wireless IC chip and the power supply circuit substrate may be connected electrically or may be coupled electromagnetically. When they are coupled electromagnetically, a capacity is formed between connection electrodes of them with a dielectric thin film, or the like. By capacitively coupling the wireless IC chip and the power supply circuit substrate, it is possible to prevent the wireless IC chip from being broken due to static electricity.

In addition, when the power supply circuit substrate is used, two electrodes of the power supply circuit substrate are coupled electromagnetically to both ends of the loop electrode 7. In addition, the electromagnetic coupling module 1 may be replaced with a single piece of wireless IC chip. In this case, two electrodes of the wireless IC chip may be directly connected to both ends of the loop electrode 7. In any cases, because the loop electrode 7 is separated from the radiation electrode 8 in terms of direct current, the wireless IC device advantageously has a resistance against static electricity.

In addition, the loop electrode 7 may have any shape as long as the loop electrode 7 is arranged so as to couple input and output terminals of the electromagnetic coupling module 1.

### Second Comparative Example

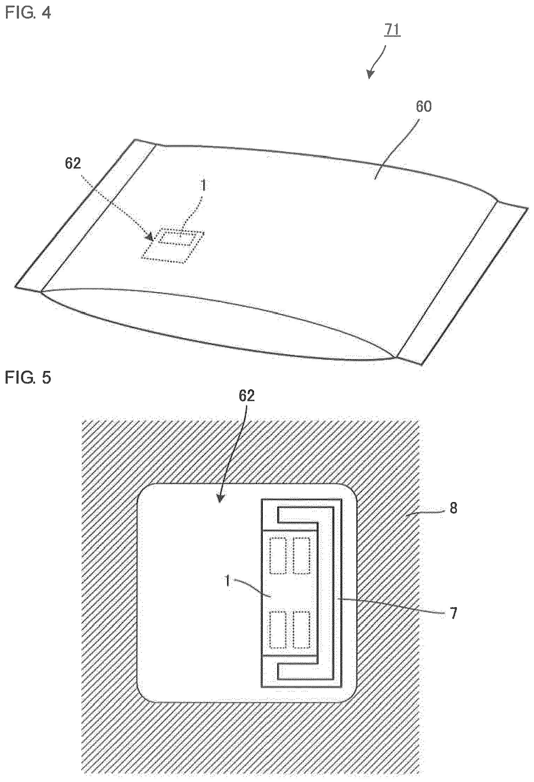

FIG. 4 is an external perspective view that shows the configuration of a wireless IC device according to a second comparative example and the configuration of an article provided with the wireless IC device. The article 71 is, for example, a packed snack. An article package 60 is a package that is formed so that an aluminum-deposited laminated film is formed into a bag-like shape.

In the example shown in FIG. 2, the electromagnetic coupling module is arranged at an edge portion of the article package, whereas in an example shown in FIG. 4, the electromagnetic coupling module 1 is provided at an inner side of the article package 60, away from the edge portion of the article package 60. The article package 60 is formed of an aluminum-deposited laminated film. Portion of the article package 60, at which aluminum is not deposited, is formed as a non-conductive portion 62. The electromagnetic coupling module 1 is arranged inside the non-conductive portion 62 and at an end of the non-conductive portion 62.

FIG. 5 is a view that shows a portion at which the electromagnetic coupling module 1 shown in FIG. 4 is mounted. In FIG. 5, the configuration of the loop electrode 7 and electromagnetic coupling module 1 is similar to that shown in FIG. 3 in the first comparative example. The radiation electrode 8 corresponds to the aluminum-deposited layer of the aluminum-deposited laminated film of the article package 60. The loop electrode 7 and the electromagnetic coupling module 1 are arranged inside the non-conductive portion 62 so that the loop electrode 7 is located adjacent to three sides of the radiation electrode 8.

With the above configuration, the loop electrode 7 operates as a magnetic field transmission auxiliary radiator. The loop electrode 7 is coupled to the radiation electrode 8 and, owing to the action similar to that shown in FIG. 3, the radiation electrode 8 operates as a radiator of an antenna.

Note that when the area of the non-conductive portion 62 is set to be equal to the area occupied by the loop electrode 7 and the electromagnetic coupling module 1 and then the loop electrode 7 and the electromagnetic coupling module 1 are arranged inside the non-conductive portion 62, the magnetic field of the loop electrode 7 is coupled to the radiation electrode 8 at four sides and, therefore, electromagnetic field induced by the radiation electrode 8 is cancelled to reduce a gain. Thus, it is important that the area of the non-conductive portion 62 is sufficiently larger than the area occupied by the loop electrode 7 and the electromagnetic coupling module 1, and the loop electrode 7 is located adjacent to the radiation electrode 8 at one side, two sides, or three sides.

### Third Comparative Example

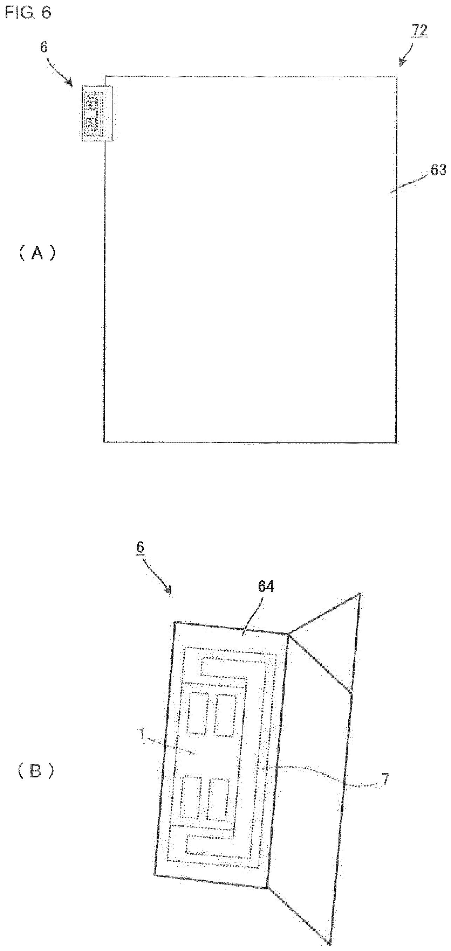

FIG. 6(B) shows the configuration of a main portion of a wireless IC device according to a third comparative example. FIG. 6(A) is an external view of an article provided with the wireless IC device. In FIG. 6(A), the article 72 is such that a main portion 6 of the wireless IC device is provided on the metal plane body 63. The metal plane body 63 is a plate-like or sheet-like article that includes a metal layer inside or a metal plate itself.

The main portion 6 of the wireless IC device has a so-called tuck index shape as a whole as shown in FIG. 6(B) and has an adhesive layer on the inner face of an insulative sheet 64. The loop electrode 7 and the electromagnetic coupling module 1 are sandwiched by the insulative sheet 64. The configuration of the loop electrode 7 and electromagnetic coupling module 1 is similar to that shown in FIG. 3.

Then, the loop electrode 7 is attached so as to be located adjacent to an edge of the metal plane body 63 shown in FIG. 6A, that is, so as to just adhere a tuck index to the edge.

Even when no cutout is provided at an edge portion of the conductive portion as described above, by bringing the loop electrode 7 of the main portion 6 of the wireless IC device close to the edge portion of the metal plane body 63, the loop electrode 7 and the metal plane body 63 (conductive portion that operates as a radiator) are coupled to each other. Thus, the metal plane body 63 operates as a radiator of an antenna.

### Fourth Comparative Example

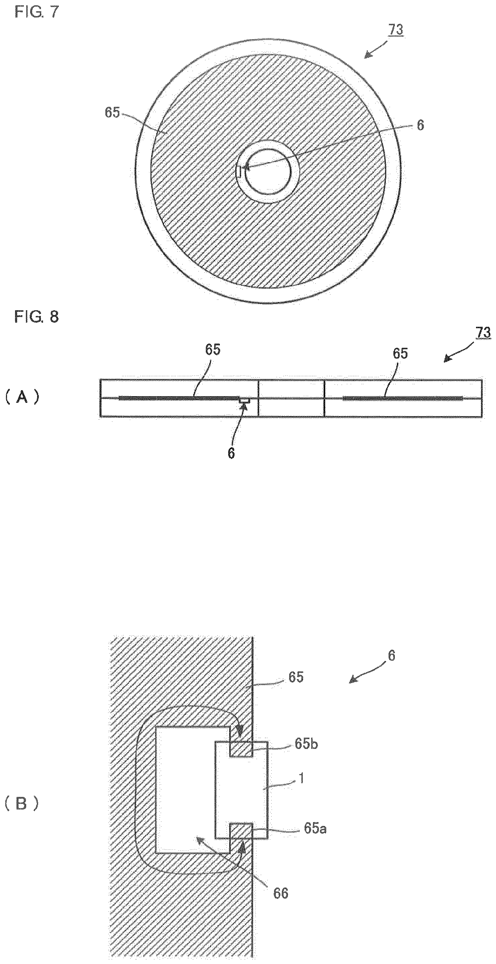

A wireless IC device according to a fourth comparative example will be described with reference to FIG. 7 and FIG. 8. The wireless IC device according to the fourth comparative example is applied to a recording medium having a metal film, such as a DVD.

FIG. 7 is a plan view of a DVD disk. FIG. 8(A) is a center cross-sectional view that is taken along the line passing the main portion 6 of the wireless IC device, and FIG. 8(B) is a partially enlarged plan view of the main portion 6 of the wireless IC device. However, the cross-sectional view of FIG. 8(A) is exaggerated in size in the thickness direction.

As shown in FIG. 7 and FIG. 8(A), the DVD disc 73 is formed by adhering two disc-shaped discs, one of the disc has a metal film 65 formed thereon, and the main portion 6 of the wireless IC device is provided at portion of the inner peripheral edge of the metal film 65.

As shown in FIG. 8(B), a C-shaped cutout portion 66 is formed at portion of the inner peripheral edge of the metal film 65. The cutout portion 66 is not a cutout of the disc but a cutout portion as a pattern of the metal film. The electromagnetic coupling module 1 is arranged so that two terminals of the electromagnetic coupling module 1, formed by the C-shaped cutout portion, face two protruding ends facing each other. The inner peripheral end (portion indicated by the arrow in the drawing) of the C-shaped cutout portion is operated as a loop electrode.

### Fifth Comparative Example

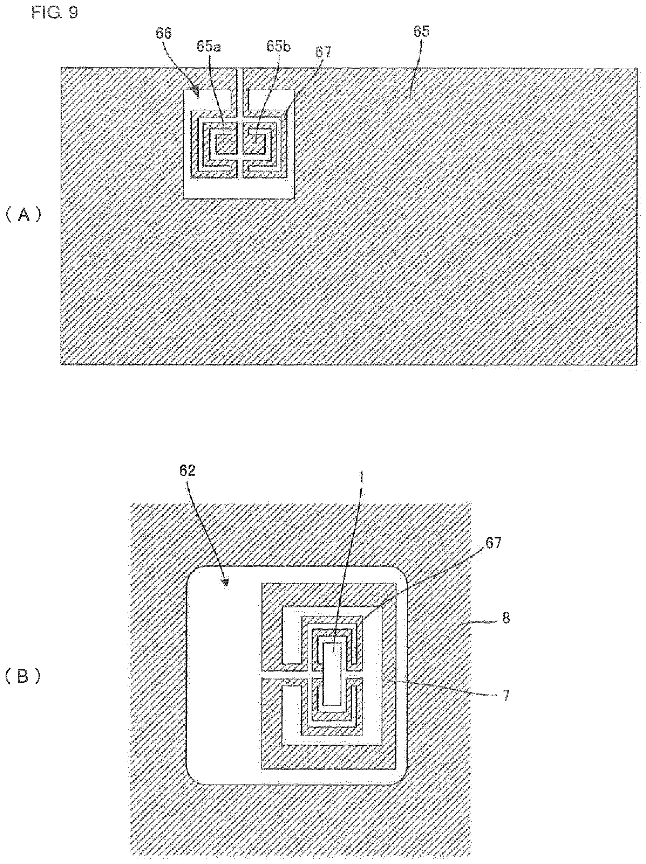

FIG. 9 is a view that shows the configuration of two wireless IC devices according to a fifth comparative example. The fifth comparative example provides a matching circuit between a mounding portion of a high-frequency device and a loop electrode. The matching circuit establishes direct electrical connection between the high-frequency device and the loop electrode.

In FIG. 9(A), the metal film 65 is formed into a sheet material or a plate material, and operates as a radiator. By forming a cutout portion 66 at portion of the metal film 65, the portion extending along the inner peripheral edge of the cutout portion 66 operates as a loop electrode.

The matching circuit 67 formed of a meander electrode and metal film portions 65a and 65b, which are mounting portions for the high-frequency device (electromagnetic coupling module or wireless IC chip), are formed inside the cutout portion 66.

By providing the matching circuit 67 in this way, the wireless IC chip may be directly mounted at the metal film portions 65a and 65b. Note that when the wireless IC chip is directly mounted on the loop electrode, the loop electrode including the matching circuit 67 substantially determines operating frequency of the wireless IC device.

In FIG. 9(B), the radiation electrode 8 has the non-conductive portion 62 formed therein, and the loop electrode 7, matching circuit 67 and electromagnetic coupling module 1 are arranged inside the non-conductive portion 62 so that the loop electrode 7 is located adjacent to three sides of the radiation electrode 8. The configuration of the matching circuit 67 and mounting portion of the electromagnetic coupling module 1 is similar to the example of FIG. 9(A).

With the above configuration, the loop electrode 7 operates as a magnetic field radiator. The loop electrode 7 is coupled to the radiation electrode 8 and, owing to the action similar to that shown in FIG. 3, the radiation electrode 8 operates as a radiator.

Note that the metal film 65 of FIG. 9(A) or the radiation electrode 8 of FIG. 9(B) may be, for example, a solid electrode that is formed on the circuit substrate inside a cellular phone terminal.

### Sixth Comparative Example

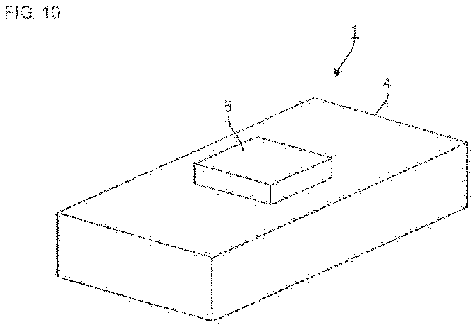

FIG. 10 is an external perspective view of an electromagnetic coupling module 1 used for a wireless IC device according to a sixth comparative example. The electromagnetic coupling module 1 may be applied to the wireless IC devices in the other embodiments. The electromagnetic coupling module 1 is formed of a wireless IC chip 5 and a power supply circuit substrate 4. The power supply circuit substrate 4 matches an impedance between the metal film 65, which operates as a radiator, and the wireless IC chip 5, and also operates as a resonant circuit.

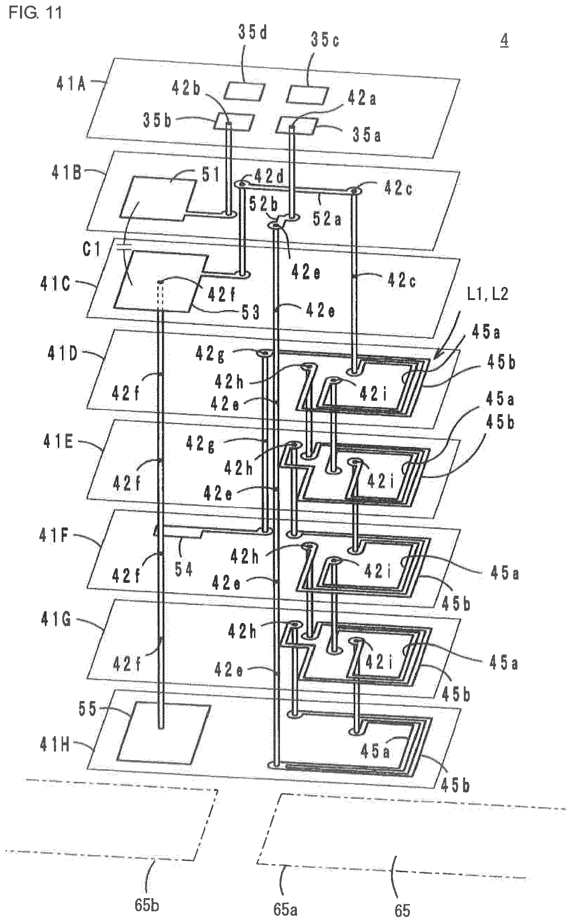

FIG. 11 is an exploded view that shows the configuration of the inside of the power supply circuit substrate 4. The power supply circuit substrate 4 is formed of a multilayer substrate formed by laminating a plurality of dielectric layers in which electrode patterns are respectively formed. Wireless IC chip mounting lands 35a to 35d are formed on the uppermost dielectric layer 41A. A capacitor electrode 51 that is electrically connected to the wireless IC chip mounting land 35b is formed on the dielectric layer 41B. A capacitor electrode 53 is formed on the dielectric layer 41C and forms a capacitor C1 with the capacitor electrode 51. Inductor electrodes 45a and 45b are formed on each of the dielectric layers 41D to 41H. The inductor electrodes 45a and 45b formed over these plurality of layers form a spiral shape as a whole, and constitute inductors L1 and L2 that are strongly inductively coupled to each other. In addition, a capacitor electrode 54 is formed on the dielectric layer 41F and is electrically connected to the inductor L1. The capacitor electrode 54 is placed between the two capacitor electrodes 53 and 55 to form a capacitor. In addition, a capacitor electrode 55 is formed on the dielectric layer 41H and is electrically connected to the capacitor electrode 53. Via holes 42a to 42i are formed to electrically connect between the electrodes of the dielectric layers.

The capacitor electrode 55 faces an end 65b of the metal film, which is formed at the cutout portion of the metal film 65 shown in FIG. 8. A capacitor between the end 65b and the capacitor electrode 55. In addition, the inductor electrodes 45a and 45b are electromagnetically coupled to the metal film portion 65a facing thereto.

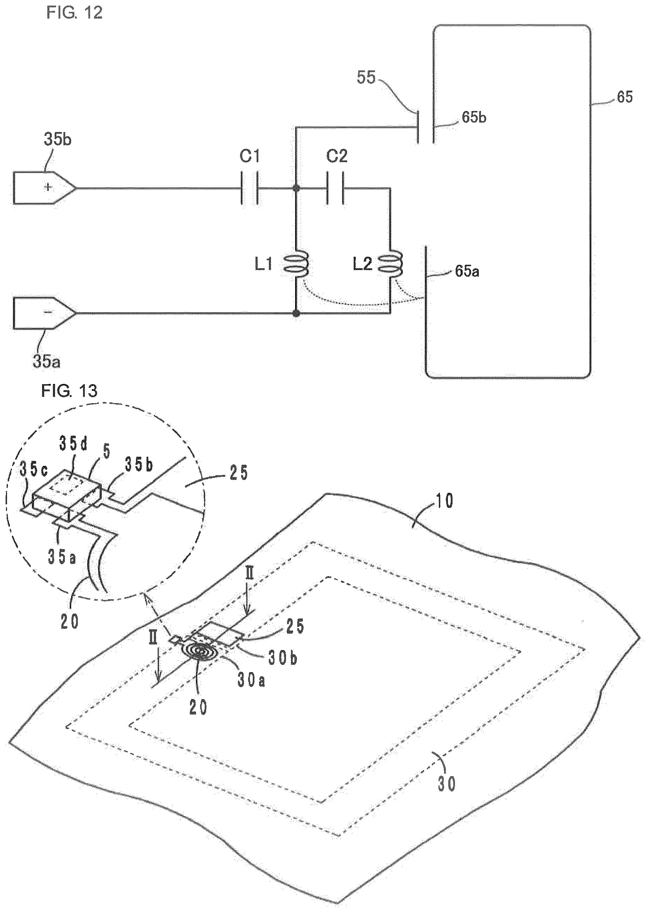

FIG. 12 is an equivalent circuit diagram that includes the power supply circuit substrate and the cutout portion of the metal film shown in FIG. 11. In FIG. 12, the capacitor C1 is a capacitor generated between the capacitor electrodes 51 and 53 shown in FIG. 11, the capacitor C2 is a capacitor generated between the capacitor electrode 54 and the capacitor electrodes 53 and 55 shown in FIG. 11, and the inductors L1 and L2 are formed by the inductor electrodes 45a and 45b shown in FIG. 11. The metal film 65 shown in FIG. 12 is a loop that extends along the inner peripheral edge of the cutout portion 66 shown in FIG. 8. The capacitor electrode 55 is capacitively coupled to one end 65b, and the other end 65a is electromagnetically coupled to the inductors L1 and L2. Thus, the loop that extends along the inner peripheral edge of the cutout portion 66 operates as a loop electrode.

Note that in the fourth comparative example, the loop that extends along the inner peripheral end of the cutout portion of the metal film is operated as the loop electrode; instead, as shown in FIG. 3, and the like, it is applicable that a loop electrode is formed inside the cutout portion, and the electromagnetic coupling module 1 that includes the wireless IC chip 5 and the power supply circuit substrate 4 are mounted to the loop electrode. In this case, the loop electrode and the metal film 65 are coupled, and the metal film 65 operates as a radiator.

In the power supply circuit substrate 4, a resonant frequency is determined in a resonant circuit formed of the inductance elements L1 and L2 and its stray capacitance. The frequency of a signal radiated from the radiation electrode is substantially determined on the basis of a self-resonant frequency of the resonant circuit.

The electromagnetic coupling module 1, which is formed so that the wireless IC chip 5 is mounted on the power supply circuit substrate 4, receives a high-frequency signal (for example, UHF frequency band) radiated from a reader/writer (not shown) through the radiation electrode, resonates the resonant circuit in the power supply circuit substrate 4 and then supplies only a reception signal of a predetermined frequency band to the wireless IC chip 5. On the other hand, the electromagnetic coupling module 1 extracts a predetermined amount of energy from the reception signal, matches information stored in the wireless IC chip 5 with a predetermined frequency in the resonant circuit using the extracted energy as a driving source, and then transmits the information to the radiation electrode. The information is further transmitted from the radiation electrode to the reader/writer.

In this way, by providing the resonant circuit in the power supply circuit substrate, selectivity of frequency increases. Thus, the operating frequency of the wireless IC device may be mostly determined using the self-resonant frequency. In accordance with the above, it is possible to transfer (exchange) energy of a signal of a frequency used in an RFID system with high efficiency. In addition, it is possible to set an optimum resonant frequency in consideration of the shape and size of a radiator. This may improve the radiation characteristic of the wireless IC device.

Note that the wireless IC chip and the mounting lands of the power supply circuit substrate may be electrically connected or may be capacitively coupled through insulation.

In addition, by providing the matching circuit in the power supply circuit substrate, it is possible to transfer (exchange) energy of a signal of a frequency used in an RFID system with high efficiency.

### Seventh Comparative Example

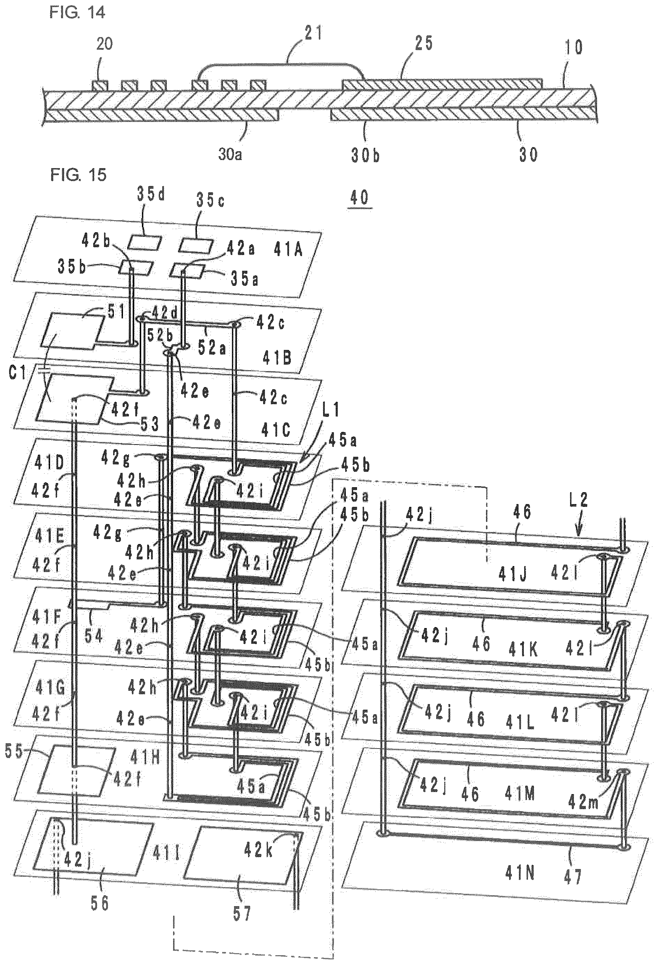

FIG. 13 is a perspective view that shows the configuration of a main portion of a wireless IC device according to a fifth comparative example. FIG. 14 is an enlarged partially cross-sectional view of FIG. 13.

In FIG. 13, a base material 10 is the base material of an article for which the wireless IC device is provided and is, for example, an aluminum-deposited laminated film. On the aluminum-deposited layer of the base material 10, a loop electrode 30 that is opened in the cutout portion described in the first comparative example or in a predetermined portion of the non-conductive portion described in the second comparative example. An inductor electrode 20 and a capacitor electrode 25 are formed above the open two ends 30a and 30b via an insulating layer. The inductor electrode 20 has a spiral shape and, as will be described later, the inside end is connected to the capacitor electrode 25.

The wireless IC chip 5 is mounted at the ends of the inductor electrode 20 and capacitor electrode 25, as shown in the enlarged view in the drawing. That is, the wireless IC chip mounting land 35a is formed at the end of the inductor electrode 20 and the wireless IC chip mounting land 35b is formed at the end of the capacitor electrode 25, and, furthermore, the mounting lands 35c and 35d are formed. Then, the wireless IC chip 5 is mounted.

FIG. 14 is a cross-sectional view that is taken along the line II-II in FIG. 13. As shown in FIG. 14, the inductor electrode 20 faces the end 30a of the loop electrode. A wire 21 connects the inside end of the inductor electrode 20 shown in FIG. 13 with the capacitor electrode 25.

In this way, capacitors and inductors for matching impedance and adjusting resonant frequency may be formed on the side of the base material 10 of an article, and the wireless IC chip 5 may be directly mounted.

### Eighth Comparative Example

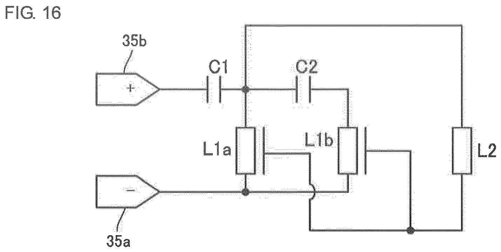

FIG. 15 is an exploded perspective view of a power supply circuit substrate 40 of a wireless IC device according to a sixth comparative example. In addition, FIG. 16 is an equivalent circuit diagram thereof.

The power supply circuit substrate 40 is formed of a multilayer substrate formed by laminating a plurality of dielectric layers in which electrode patterns are respectively formed. Wireless IC chip mounting lands 35a to 35d are formed on the uppermost dielectric layer 41A. A capacitor electrode 51 that is electrically connected to the wireless IC chip mounting land 35b is formed on the dielectric layer 41B. A capacitor electrode 53 is formed on the dielectric layer 41C and forms a capacitor C1 with the capacitor electrode 51. Inductor electrodes 45a and 45b are formed on each of the dielectric layers 41D to 41H. The inductor electrodes 45a and 45b formed over these plurality of layers constitute, as a whole, an inductor L1 that has a spiral shape. In addition, a capacitor electrode 54 is formed on the dielectric layer 41F and is electrically connected to the inductor L1. The capacitor electrode 54 is placed between the two capacitor electrodes 53 and 55 (or 56) to form a capacitor. In addition, a capacitor electrode 55 is formed on the dielectric layer 41H and is electrically connected to the capacitor electrode 53.

Capacitor electrodes 56 and 57 are formed on a dielectric layer 411. The capacitor electrode 56 is electrically connected to the capacitor electrodes 53 and 55. In addition, the capacitor electrode 57 is electromagnetically coupled to the inductor electrodes 45a and 45b.

Inductor electrodes 46 and 47 are formed on each of dielectric layers 41J to 41N. The inductor electrodes 46 and 47 form a loop electrode L2 that is wound multiple times. Via holes 42a to 42m are formed to electrically connect between the electrodes of the dielectric layers.

That is, the power supply circuit substrate 40 is just formed so that the loop electrode is included in the power supply circuit substrate 4 shown in FIG. 11. Thus, by installing the electromagnetic coupling module, which is formed by mounting the wireless IC chip on the power supply circuit substrate 40, to an article, the wireless IC device may be formed, and it is not necessary to form a loop electrode on the article side.

In FIG. 16, the capacitor C1 is a capacitor generated between the capacitor electrodes 51 and 53 shown in FIG. 15, the capacitor C2 is a capacitor generated between the capacitor electrode 54 and the capacitor electrodes 53 and 55 shown in FIG. 15, the inductors L1a and L1b are respectively formed by the inductor electrodes 45a and 45b shown in FIG. 15, and the inductor L2 is formed by the inductor electrodes 46 and 47 shown in FIG. 15. Ninth Comparative Example

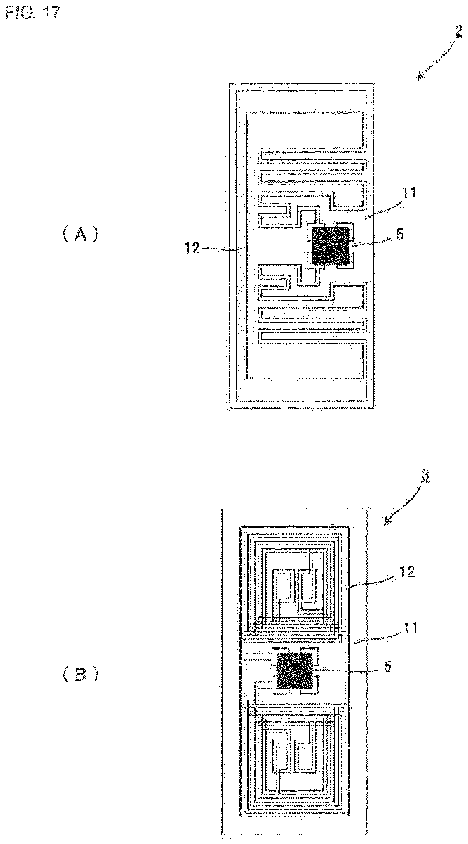

FIG. 17 are plan views of an electromagnetic coupling module used for a wireless IC device according to a seventh comparative example. In the example of FIG. 17(A), a loop electrode 12 and wireless IC chip mounting lands are formed on the substrate 11 by an electrode pattern, and the wireless IC chip 5 is mounted.

In the example shown in FIG. 15, the capacitors and inductors for matching impedance and adjusting resonant frequency are formed on the power supply circuit substrate together with the loop electrode, whereas in the example shown in FIG. 17, the loop electrode and the wireless IC chip basically integrated.

In the example of FIG. 17(B), spiral electrode patterns are respectively formed on the top and bottom faces of the substrate 11, capacitor electrode that places the substrate 11 in between are arranged at the center of each spiral electrode pattern, and then the line on the top face and the line on the bottom face are connected via the capacitors. That is, the line length and inductance are gained within a limited area by utilizing both faces of the substrate 11 to thereby form the loop electrode 12.

Two electromagnetic coupling modules 2 and 3 shown in FIG. 17 each are arranged adjacent to a metal film of an article, which operates as a radiator, or a metal plate so that the radiation electrode is capacitively coupled to the loop electrode 12. By so doing, without forming any specific circuit on the article side, as in the case of the first and second comparative examples, it is possible to utilize the metal film of the article or the metal plate as a radiator of an antenna.

### First Embodiment

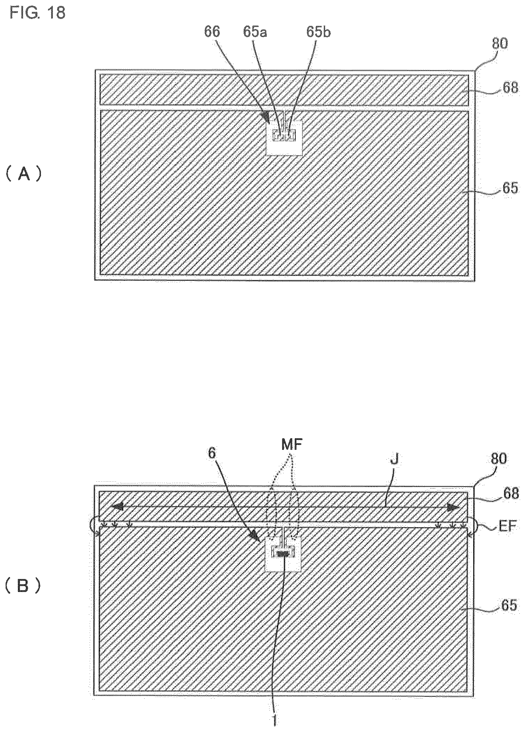

FIG. 18 are views that show the configuration of a wireless IC device according to a first embodiment. In the first to ninth comparative examples, the article package 60, the metal plane body 63, the metal film 65, and the like, in which a conductive plane extends in a planar manner, are operated as a radiator, whereas in the first embodiment, a resonant conductor that is insulated from a planar conductive plane and that operates as a resonator is provided.

FIG. 18(A) is a plan view of a conductive pattern on a printed wiring substrate when an RFID tag is formed on the printed wiring substrate. In addition, FIG. 18(B) is a plan view of a wireless IC device that operates as an RFID tag, which is formed so that the electromagnetic coupling module 1 formed of a wireless IC chip and a power supply circuit substrate is mounted on the printed wiring substrate.

A metal film 65, which is used as a ground electrode of another circuit, is formed on the upper face of the printed wiring substrate 80. The metal film 65 partially forms a cutout portion (metal film non-formation portion) 66, and the metal film portions 65a and 65b, which form a mounting portion for a high-frequency device (electromagnetic coupling module or wireless IC chip), are formed inside the cutout portion 66.

As shown in FIG. 18(B), by mounting the high-frequency device 1 on the metal film portions 65a and 65b, the portion that extends along the inner peripheral edge of the cutout portion 66 operates as a loop electrode. The mounting area of the high-frequency device 1 forms a main portion 6 of the wireless IC device.

A resonant conductor 68 that is coupled to the high-frequency device 1 is formed on the upper face of the printed wiring substrate 80. The resonant conductor 68 has determined dimensions (particularly, length) so that the resonant frequency is a frequency used in an RFID tag or a frequency therearound. For example, when a glass epoxy substrate is used and the operating frequency is a UHF band, the length of the resonant conductor 68 just needs to be several tens centimeters so as to operate as a both-end-open half-wavelength resonator.

The resonant conductor 68 is arranged so that the center is located adjacent to the loop electrode of the main portion 6 of the wireless IC device, so as to be coupled to the high-frequency device 1. In addition, in this example, it is arranged along one side of the metal film 65 in an insulated manner.

In FIG. 18(B), the arrow J shown in the resonant conductor 68 typically represents an electric current path, the arrow EF typically represents an electric field distribution, and the arrow MF typically represents a magnetic field distribution. In this way, the magnitude of an electric current that flows through the resonant conductor 68 becomes maximum around the center. Thus, the magnetic field generated at the resonant conductor 68 becomes maximum around the center, and the resonant conductor 68 is strongly magnetically coupled to the portion of the loop electrode, extending along the inner peripheral edge of the cutout portion 66.

When the resonant conductor 68 is resonating around the operating frequency of the RFID tag, an electric current that flows through the resonant conductor 68 and a voltage generated across both ends of the resonant conductor 68 increases. Owing to the magnetic field and electric field generated by these electric current and voltage as well, the resonant conductor 68 is coupled to the metal film 65.

The peak of a voltage of a standing wave generated at the resonant conductor 68 is formed at an end of the resonant conductor 68. In this example, because the length of the resonant conductor 68 is substantially equal to one end of the metal film 65 that operates as a radiator, the resonant conductor 68 is strongly coupled to the metal film 65. Thus, a high gain is obtained. Through the actions described above, it is possible to obtain an excellent characteristic as an RFID tag.

When no resonant conductor 68 is present, resonance just needs to be performed in the metal film 65 at the operating frequency of an RFID tag; however, due to restriction on size of the metal film 65 and depending on components mounted on the printed wiring substrate, resonant frequency shifts. According to the embodiment, because the metal film 65 is separated from the resonant conductor 68, the resonant conductor 68 may be designed as a single unit, and a shift in resonant frequency due to mounted components also does not occur.

Note that in the first embodiment, only the metal film, as a ground electrode, and the resonant conductor are described as an electrode pattern formed on the printed wiring substrate; however, an electrode pattern is appropriately determined on the basis of a circuit to be formed and an electronic component to be mounted. This also applies to other embodiments described below.

When an RFID tag is formed on the above constructed printed wiring substrate, and information such as manufacturing process history is written to the RFID tag, it is possible to manage, for example, a process of mounting components to a printed wiring substrate. For example, when malfunction of an electronic component is detected in lot unit, it is possible to take measures only by withdrawing a small number of electronic devices that have the electronic component included in that lot. In addition, it has an advantageous effect such that post-sales support and maintenance at the time when the product is in operation in the market may be quickly performed, and a process for recycling as a resource after disposal will be simple.

In addition, after process management is ended, portion of the printed wiring substrate, forming the resonant conductor 68, may be torn off. By so doing, the size of the printed wiring substrate may be small, and it is possible to reduce the size of a product without losing the function of an RFID tag. Because the resonant conductor 68 is present at the time of process management, data may be read even when the output level of a reader/writer is low. By lowering the output of an RF signal, it is possible to suppress malfunction of a control device, a characteristic measurement device, and the like. Furthermore, after the resonant conductor 68 is torn off, the metal film 65 also operates as a radiator. Thus, communication is still possible although a communicable distance with a reader/writer is reduced.

When the printed wiring substrate is conveyed in a general manufacturing process, rails may be arranged on both sides of the printed wiring substrate and then the printed wiring substrate may be conveyed on the rails. In order to prevent breakage of the portions that contact the rails, the printed wiring substrate has a margin portion that will be finally torn off. If the resonant conductor 68 is formed at the margin portion, wasted space of the printed wiring substrate is removed.

Note that the metal film 65, which is a ground electrode, may be formed in a plurality of layers of the printed wiring substrate. In this case, the region of the cutout portion 66 in each layer is formed as a metal film non-formation portion so that a magnetic flux passes therethrough.

According to the embodiment, a radiation gain at the operating frequency of an RFID tag increases, and an excellent characteristic of an RFID is obtained. In addition, because the resonant frequency of the resonant conductor is not influenced by components mounted on the printed wiring substrate, design is easy.

### Second Embodiment

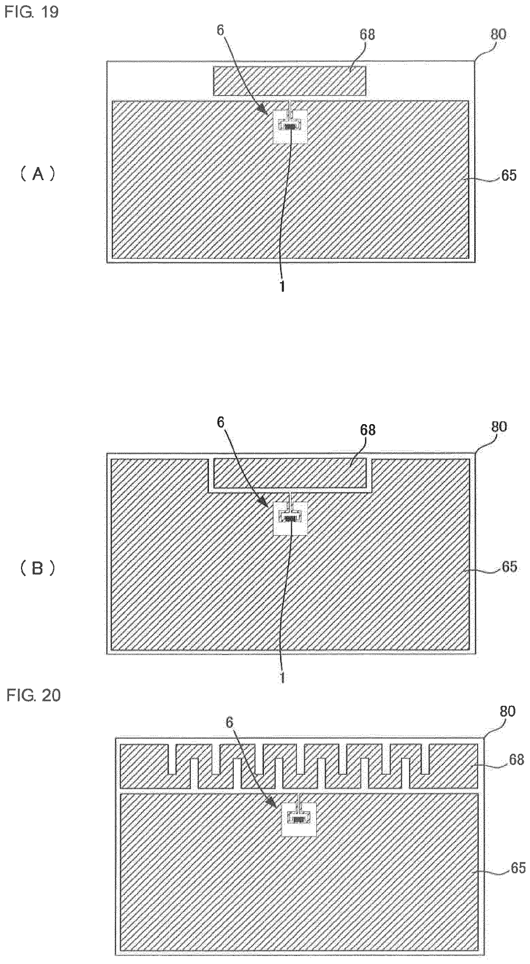

FIG. 19 to FIG. 21 are views that show some configurations of a wireless IC device according to a second embodiment. Any drawings are plan views of a wireless IC device such that an RFID tag is formed on a printed wiring substrate.

In the examples of FIGs. 19(A) and (B), the metal film 65, which is used as a ground electrode for another circuit, is formed on the upper face of the printed wiring substrate 80. The metal film 65 partially forms a cutout portion (metal film non-formation portion), and a high-frequency device (electromagnetic coupling module or wireless IC chip) is mounted inside the cutout portion, so that the main portion 6 of the wireless IC device similar to that shown in FIG. 18 is formed.

The configuration differs from the configuration shown in FIG. 18 in that the length of the resonant conductor 68 is smaller than one side of the metal film 65 as a radiator. In the example of FIG. 19(A), the resonant conductor 68 is formed along one side of the metal film 65. In the example of FIG. 19(B), the resonant conductor 68 is formed at a position that is separated from an area in which the metal film 65 is formed.

Even with the above relationship, when the printed wiring substrate 80 and the metal film 65 are large in area (long) and a resonance frequency owing to the metal film 65 is low, the resonant frequency of the resonant conductor 68 may be set to around the operating frequency of an RFID. Thus, a high gain is obtained.

In the example of FIG. 20, the resonant conductor 68 is formed in a meander line shape and the entire of the resonant conductor 68 is arranged along one side of the metal film 65.

According to the above configuration, because the resonator length may be increased even when the profile of the resonant conductor 68 is short, a high gain may be obtained when it is resonated at a relatively low frequency.

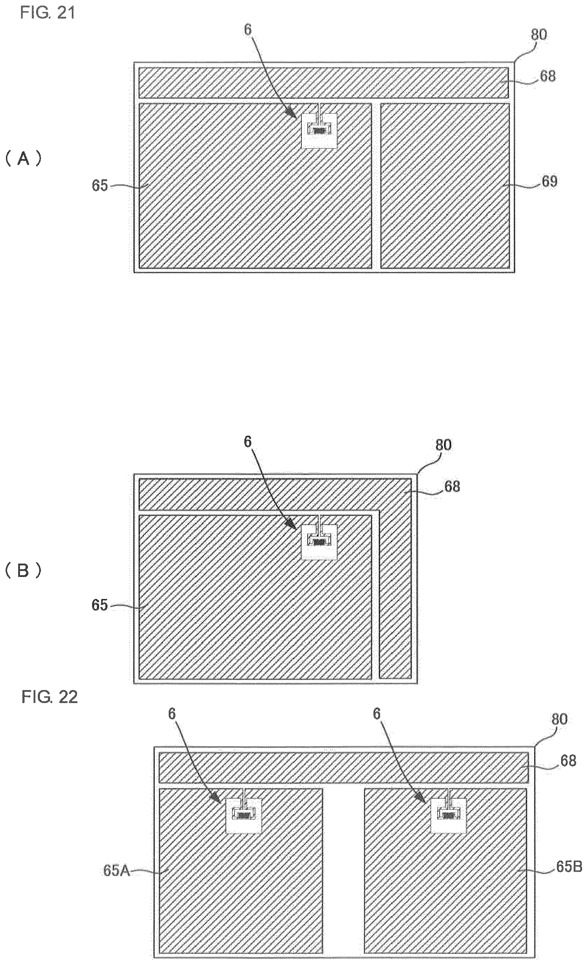

In the example of FIG. 21, the resonant conductor 68 is longer than one side of the metal film 65 that is operated as a radiator. In addition, a main portion 6 of the wireless IC device is formed at a position shifted from the center of one side of the metal film 65 that is operated as a radiator. In this case as well, as shown in FIGs. 21(A) and (B), the center of the resonant conductor 68 just needs to be arranged adjacent to the loop electrode of the main portion 6 of the wireless IC device.

In the example shown in FIG. 21(A), a metal film 69 for forming another ground electrode or another circuit is formed in a margin at a position adjacent to the metal film 65. In addition, in the example of FIG. 21(B), the resonant conductor 68 is formed along two sides of the metal film 65.

In this way, even when the pattern of the metal film 65 that operates as a radiator is small, a high gain is obtained by providing the resonant conductor 68 having a length that gives a necessary resonant frequency.

### Third Embodiment

FIG. 22 is a view that shows the configuration of a wireless IC device according to a third embodiment. In FIG. 22, the main portion 6 of the wireless IC device similar to that shown in FIG. 18 is formed in each of two metal films 65A and 65B on the upper face of a printed wiring substrate 80. Then, a resonant conductor 68 is formed so as to be coupled to both high-frequency devices provided at the main portions 6 of the two wireless IC devices. That is, one resonant conductor 68 is shared by two high-frequency devices.

For example, the printed wiring substrate 80 may form RFID tags having different frequency bands (for example, even in the same UHF band, a frequency of standards in accordance with a destination) by being finally torn off into the side at which a metal film 65A is formed and the side at which a metal film 65B is formed.

When the resonant conductor 68 is longer than one side of the metal film 65 that operates as a radiator, the resonant conductor 68 may be easily shared as a resonator for a plurality of high-frequency devices as described above. In addition, even when shared frequencies are different, the resonant frequency just needs to be set to a frequency approximate to the frequencies used in the plurality of RFID tags.

When the resonant conductor 68 is used only in the manufacturing process, it will be separated from the printed wiring substrate 80 later. Thus, the mother printed wiring substrate does not have a wasted space of an electrode pattern, so that it is possible to avoid an increase in cost due to formation of the resonant conductor 68.

### Fourth Embodiment

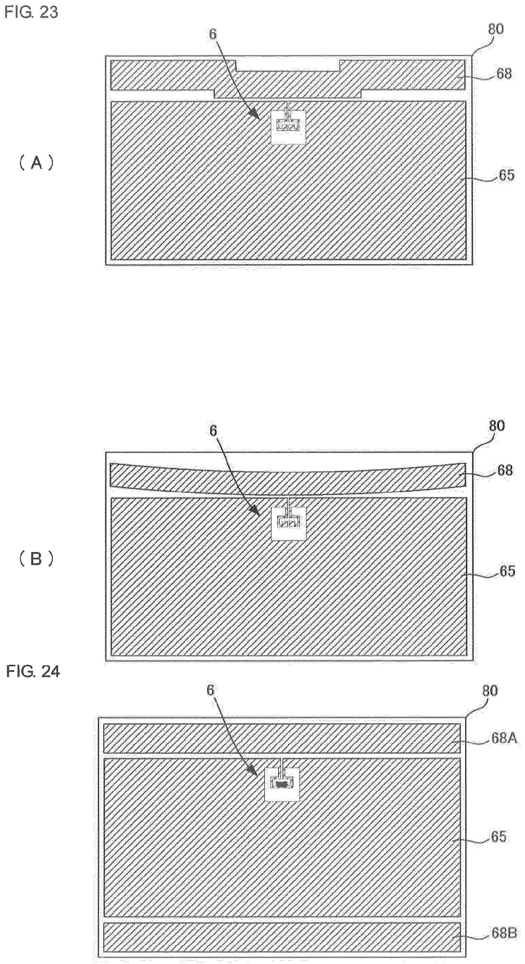

FIG. 23 is a view that shows some configurations of a wireless IC device according to a fourth embodiment. Any drawings are plan views of a wireless IC device such that an RFID tag is formed on a printed wiring substrate.

In the examples of FIGs. 23(A) and (B), the metal film 65, which is used as a ground electrode for another circuit, is formed on the upper face of the printed wiring substrate 80. A main portion 6 of the wireless IC device similar to that shown in FIG. 18 is formed at portion of the metal film 65.

The configuration differs from the configuration shown in FIG. 18 in that only a portion around the center of the resonant conductor 68 is arranged adjacent to the loop electrode of the main portion 6 of the wireless IC device. Depending on the relationship between the length of one side of the metal film 65 that operates as a radiator and the length of the resonant conductor 68, portions near both ends of the resonant conductor 68 may be formed in a shape so as to be located away from the metal film 65 as described above.

### Fifth Embodiment

FIG. 24 is a plan view that shows the configuration of a wireless IC device according to a fifth embodiment. The configuration differs from the configuration shown in FIG. 18 in that resonant conductors 68A and 68B are respectively arranged along two sides of the metal film 65 as a radiator.

One resonant conductor 68A, as in the case shown in FIG. 18, is strongly coupled to a high-frequency device provided at the main portion 6 of the wireless IC device. The other resonant conductor 68B is located adjacently along the metal film 65. Thus, the other resonant conductor 68B is coupled to the high-frequency device via an electromagnetic field distributed in the metal film 65. Both the resonant conductors 68A and 68B operate as a both-end-open half-wavelength resonator.

The plurality of resonant conductors 68 are not limited to that they are arranged along two opposite sides of the metal film 65; they may be arranged along sides of the metal film 65, which are perpendicular to each other.

### Sixth Embodiment

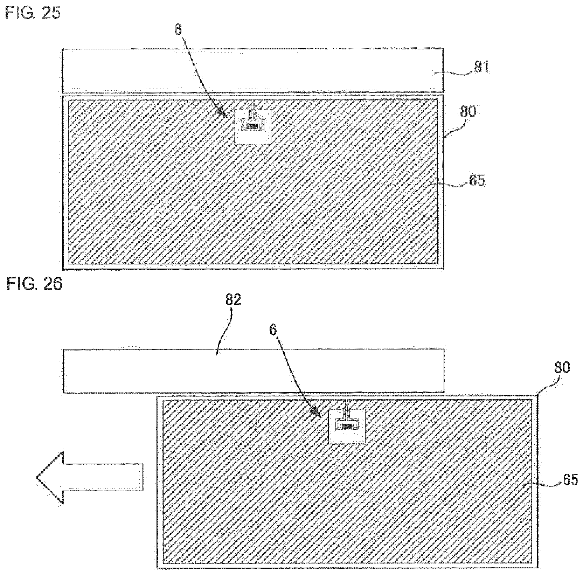

FIG. 25 is a plan view that shows the configuration of a wireless IC device according to a sixth embodiment. In the first to fifth embodiments, the resonant conductor is formed on the printed wiring substrate, whereas in the sixth embodiment, a metal case of a device, on which the wireless IC device is mounted, or a mounting destination component 81, such as a mounting component, also serves as the resonant conductor.

With the above configuration, the metal case of the device, on which the wireless IC device is mounted, the mounting component, or the like, operates as a resonator. Thus, it is not necessary to form a resonant conductor on the printed wiring substrate. This can reduce the size of the printed wiring substrate 80 and, hence, the cost may be reduced.

### Seventh Embodiment

In the seventh embodiment, a resonant conductor is fixed, and at the time when a printed wiring substrate is conveyed along a process line, the printed wiring substrate communicates with a reader/writer.

FIG. 26 is a plan view that shows the configuration of a wireless IC device according to the seventh embodiment. In FIG. 26, a process line installed conductor 82 is arranged along the process line along which the printed wiring substrate 65 is conveyed. The reader/writer is arranged at a position relatively close to the process line installed conductor 82 (but not necessarily adjacent position).

A main portion 6 of a wireless IC device similar to that shown in FIG. 18 is formed on the metal film 65 of the printed wiring substrate 80.

When the printed wiring substrate 80 is conveyed along the process line and the main portion 6 of the wireless IC device is located adjacent to the process line installed conductor 82, the process line installed conductor 82 operates as a resonator that resonates at the frequency of an RFID tag. Thus, it is possible to communicate with the reader/writer with a high gain in that state.

According to the above configuration and communication method, because no resonant conductor is required on the printed wiring substrate, the area of a wirable portion increases. In addition, because it operates as an RFID tag only when the printed wiring substrate 80 is located close to the process line installed conductor 82, it is possible to communicate only with an RFID tag placed at a specific position. That is, it is possible to selectively communicate only with a desired RFID tag without communicating with an unintended ambient RFID tag.

### Eighth Embodiment

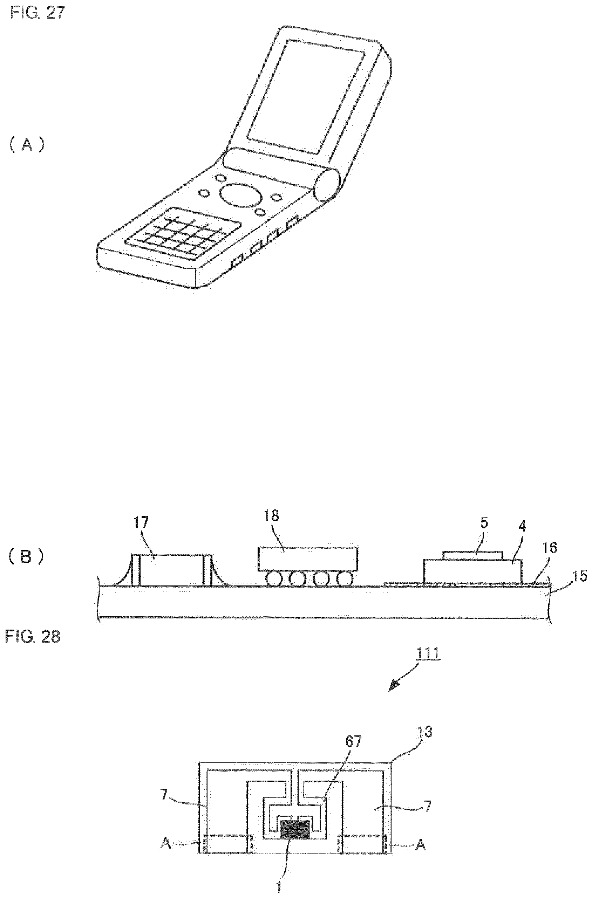

FIG. 27(A) is a perspective view of a cellular phone terminal provided with a wireless IC device, and FIG. 27(B) is a cross-sectional view of a main portion of an internal circuit substrate. The power supply circuit substrate 4, on which the wireless IC chip 5 is mounted, is installed on the circuit substrate 15 inside a cellular phone terminal, together with electronic components 17 and 18. An electrode pattern 16 that spreads in a predetermined area is formed on the upper face of the circuit substrate 15. The electrode pattern 16 is coupled to the wireless IC chip 5 via the power supply circuit substrate 4 to operate as a radiator.

In addition, as another example, a wireless IC device may be formed at a metal panel provided at the rear face of an internal component (for example, liquid crystal panel) of the cellular phone terminal shown in FIG. 27(A). That is, the metal panel may be operated as a radiator of an antenna by applying the wireless IC device shown in the first to seventh comparative examples.

### Ninth Embodiment

In the example shown in FIG. 9(A), the metal film 65 that operates as a radiator is formed in a sheet material or a plate material, and the metal film 65 partially forms the cutout portion 66, so that the portion extending along the inner peripheral edge of the cutout portion 66 is operated as the loop electrode. When the above configuration is applied to the printed wiring substrate, a characteristic as an RFID tag fluctuates depending on a circuit formed on the printed wiring substrate. Thus, the degree of difficulty in designing of the printed wiring substrate increases. A ninth embodiment eliminates the above problem.

FIG. 28 is a plan view that shows the configuration of a component for a wireless IC device according to the ninth embodiment. A mounting portion, on which an electromagnetic coupling module 1 is mounted, a matching circuit 67, and a loop electrode 7, which is a liner electrode, are formed on a printed wiring substrate 13, such as a glass epoxy substrate. The ends of the loop electrode 7 are extended to an end of one side of the printed wiring substrate 13 as soldering electrode portions indicated by A. The electromagnetic coupling module 1 is mounted on the printed wiring substrate 13 to form a component 111 for a wireless IC device.

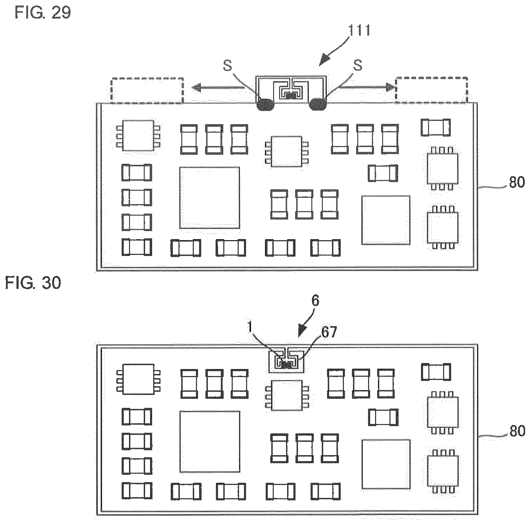

FIG. 29 is a plan view that shows a wireless IC device that uses the component for a wireless IC device according to the ninth embodiment. As shown in FIG. 29, the component 111 for a wireless IC device is soldered to a position at which the loop electrode of the printed wiring substrate 80 will be formed. When a resist film is coated on the electrodes of the printed wiring substrate 80, the resist film is peeled off with a router, or the like, to be ready for soldering. In this state, characteristics, such as a reading distance as an RFID tag, and an influence of ambient wires, a casing, or the like, when assembled to a device are checked.

When an optimum position is determined on the basis of the result of checking of the characteristics, and the like, as shown in FIG. 30, the matching circuit 67 and a mounting portion for the electromagnetic coupling module 1 are formed at a position close to a position, at which the component 111 for a wireless IC device is assembled, within a ground electrode formation area on the printed wiring substrate 80, and then the electromagnetic coupling module 1 is mounted. By so doing, the main portion 6 of the wireless IC device is formed on the printed wiring substrate 80.

### Tenth Embodiment

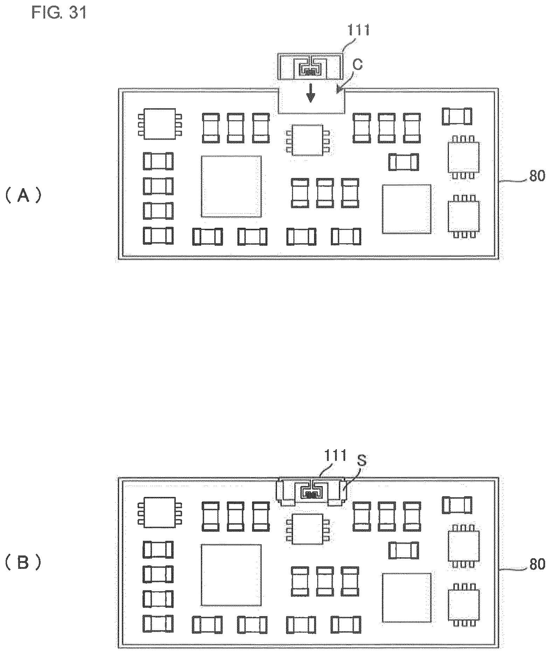

FIG. 31 are plan views that show the configuration of a component for a wireless IC device according to a tenth embodiment and the configuration of a wireless IC device provided with that component.

In this example, as shown in FIG. 31(A), the printed wiring substrate 80 has a cutout portion C formed at a position at which the component 111 for a wireless IC device is assembled, and then as shown in FIG. 31(B), the component 111 for a wireless IC device is assembled to the position through soldering. Soldering should be performed over the entire portions at which the electrodes contact.

With the above configuration, the state in which the component 111 for a wireless IC device is assembled is nearer to the final shape than that in the example shown in FIG. 29. Thus, further accurate design may be performed.

### Eleventh Embodiment

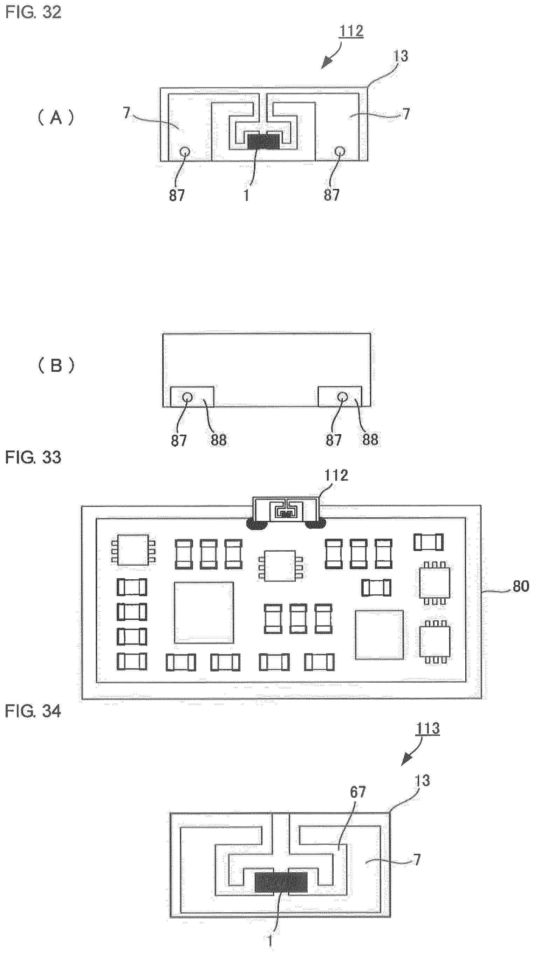

FIG. 32 are plan views that show the configuration of a component for a wireless IC device according to an eleventh embodiment. FIG. 33 is a plan view that shows the configuration of a wireless IC device provided with the component for a wireless IC device.

In this example, soldering electrode portions 88 are formed on the rear side of the component for a wireless IC device, and are connected to the loop electrode 7 on the front face via through-holes 87, or the like. As shown in FIG. 33, the soldering electrode portions 88 are soldered to the ground electrode of the printed wiring substrate 80.

In this way, by providing the soldering electrode portions 88 on the rear face, even when the position at which the ground electrode is formed does not spread to the edge of the printed wiring substrate 80, it may be easily mounted on the printed wiring substrate 80. Twelfth Embodiment

FIG. 34 is a plan view that shows the configuration of a component 113 for a wireless IC device according to a twelfth embodiment. A mounting portion, on which the electromagnetic coupling module 1 is mounted, the matching circuit 67, and the loop electrode 7 are formed on a printed wiring substrate 13, such as a glass epoxy substrate. The loop electrode 7 differs from the example shown in FIG. 28 in that the ends of the linear electrode are electrically connected to form a loop electrode.

The electromagnetic coupling module 1 is mounted on the printed wiring substrate 13 to form the component 113 for a wireless IC device. The component 113 for a wireless IC device, as in the case of the one shown in FIG. 29 or FIG. 31, is assembled to the printed wiring substrate.

In the component 113 for a wireless IC device, the loop electrode 7 is not influenced by a state of soldering, or the like, highly accurate design with less fluctuations in impedance, or the like, may be achieved. In addition, when it is used as an electronic component, variations in characteristic are small.

Note that in the above described embodiments, the wireless IC of the electromagnetic coupling module employs the wireless IC chip; however, the invention is not limited to the one using the wireless IC chip. For example, an organic semiconductor circuit may be formed on a substrate to form the wireless IC.

## Claims

1. A wireless IC device comprising:
a printed wiring substrate (80);
a ground electrode (65, 69) provided on the printed wiring substrate (80), wherein the ground electrode (65, 69) is a metal film, and the ground electrode is configured to be used as a ground electrode for another circuit;
a high-frequency device including a wireless IC chip (5) and mounted to the printed wiring substrate (80); and
a loop electrode connected to the wireless IC chip (5),
wherein the loop electrode is defined by at least one of a portion of the ground electrode (65, 69) or a conductive member (7) that is different from the ground electrode (65, 69) and is coupled to the ground electrode (65, 69); and
wherein the ground electrode (65, 69) defines a radiation electrode that is configured to radiate an electromagnetic field, **characterized in that** the high-frequency device comprises the wireless IC chip (5) and a power supply circuit substrate (4), wherein the wireless IC chip (5) is mounted to the printed wiring substrate (80) via the power supply circuit substrate (4),
further comprising at least one resonant circuit provided in the power supply circuit substrate (4).

2. The wireless IC device according to claim 1, wherein
the loop electrode is defined by a cutout portion (66) at an edge of ground electrode (65, 69), and
the high-frequency device is arranged at the cutout portion (66) and is connected to the ground electrode (65, 69) at the cutout portion of the ground electrode (65, 69).

3. The wireless IC device according to Claim 1 or 2, wherein the loop electrode is provided at a mounting portion, at which the high-frequency device is mounted, so that a loop plane of the loop electrode is arranged in a direction of a plane of the radiation electrode.

4. The wireless IC device according to claim 3, further comprising:
a matching circuit (67) provided between the mounting portion of the high-frequency device and the loop electrode, wherein
the matching circuit directly electrically connects the high-frequency device with the loop electrode.

5. The wireless IC device according to Claim 1, wherein a resonant frequency of the at least one resonant circuit corresponds to a frequency of a signal exchanged by the radiation electrode.

6. The wireless IC device according to any one of Claims 1 to 5, further comprising:
a resonant conductor (68) having a resonant frequency that is equal to an operating frequency of the high-frequency device, wherein
the resonant conductor (68) is coupled to the high-frequency device.

7. The wireless IC device according to Claim 6, wherein the resonant conductor (68) is arranged parallel to an edge portion of the radiation electrode.

8. The wireless IC device according to Claim 6 or 7, wherein the resonant conductor (68) has a length that is equal to a side of the radiation electrode that is located adjacent the resonant conductor.

9. The wireless IC device according to any one of Claims 6 to 8, wherein the resonant conductor (68) is arranged such that a center portion of the resonant conductor (68) is located adjacent to a location of the high-frequency device.

10. The wireless IC device according to any one of Claims 6 to 9, wherein a plurality of the high-frequency devices are provided, and the resonant conductor (68) is coupled to each of the high-frequency devices.

11. The wireless IC device according to any one of Claims 6 to 10, wherein the resonant conductor (68) is separable from the radiation electrode.

## Patentansprüche

1. Ein Drahtlos-IC-Bauelement, das folgende Merkmale aufweist:
ein gedrucktes Verdrahtungssubstrat (80);
eine Masseelektrode (65, 69), die an dem gedruckten Verdrahtungssubstrat (80) vorgesehen ist, wobei die Masseelektrode (65, 69) ein Metallfilm ist und die Masseelektrode ausgebildet ist, um als eine Masseelektrode für eine andere Schaltung verwendet zu werden;
ein Hochfrequenzbauelement, das einen Drahtlos-IC-Chip (5) aufweist und an dem gedruckten Verdrahtungssubstrat (80) befestigt ist; und
eine Schleifenelektrode, die mit dem Drahtlos-IC-Chip (5) verbunden ist,
wobei die Schleifenelektrode durch zumindest einen eines Abschnitts der Masseelektrode (65, 69) oder eines leitfähigen Bauteils (7) definiert ist, das sich von der Masseelektrode (65, 69) unterscheidet und mit der Masseelektrode (65, 69) gekoppelt ist; und
wobei die Masseelektrode (65, 69) eine Strahlungselektrode definiert, die ausgebildet ist, um ein elektromagnetisches Feld abzustrahlen,
**dadurch gekennzeichnet, dass**:
das Hochfrequenzbauelement den Drahtlos-IC-Chip (5) und ein Leistungsversorgungsschaltungssubstrat (4) aufweist, wobei der Drahtlos-IC-Chip (5) über das Leistungsversorgungsschaltungssubstrat (4) an dem gedruckten Verdrahtungssubstrat (80) befestigt ist,
dasselbe ferner zumindest eine Resonanzschaltung aufweist, die in dem Leistungsversorgungsschaltungssubstrat (4) vorgesehen ist.

2. Das Drahtlos-IC-Bauelement gemäß Anspruch 1, bei dem:
die Schleifenelektrode durch einen Ausschnittabschnitt (66) an einem Rand der Masseelektrode (65, 69) definiert ist, und
das Hochfrequenzbauelement an dem Ausschnittabschnitt (66) angeordnet ist und an dem Ausschnittabschnitt der Masseelektrode (65, 69) mit der Masseelektrode (65, 69) verbunden ist.

3. Das Drahtlos-IC-Bauelement gemäß Anspruch 1 oder 2, bei dem die Schleifenelektrode an einem Befestigungsabschnitt vorgesehen ist, an dem das Hochfrequenzbauelement befestigt ist, so dass eine Schleifenebene der Schleifenelektrode in einer Richtung einer Ebene der Strahlungselektrode angeordnet ist.

4. Das Drahtlos-IC-Bauelement gemäß Anspruch 3, das ferner folgendes Merkmal aufweist:
eine Anpassungsschaltung (67), die zwischen dem Befestigungsabschnitt des Hochfrequenzbauelements und der Schleifenelektrode vorgesehen ist, wobei:
die Anpassungsschaltung das Hochfrequenzbauelement direkt elektrisch mit der Schleifenelektrode verbindet.

5. Das Drahtlos-IC-Bauelement gemäß Anspruch 1, bei dem eine Resonanzfrequenz der zumindest einen Resonanzschaltung einer Frequenz eines Signals entspricht, das durch die Strahlungselektrode ausgetauscht wird.

6. Das Drahtlos-IC-Bauelement gemäß einem der Ansprüche 1 bis 5, das ferner folgendes Merkmal aufweist:
einen Resonanzleiter (68) mit einer Resonanzfrequenz, die gleich einer Betriebsfrequenz des Hochfrequenzbauelements ist, wobei:
der Resonanzleiter (68) mit dem Hochfrequenzbauelement gekoppelt ist.

7. Das Drahtlos-IC-Bauelement gemäß Anspruch 6, bei dem der Resonanzleiter (68) parallel zu einem Randabschnitt der Strahlungselektrode angeordnet ist.

8. Das Drahtlos-IC-Bauelement gemäß Anspruch 6 oder 7, bei dem der Resonanzleiter (68) eine Länge aufweist, die gleich einer Seite der Strahlungselektrode ist, die benachbart zu dem Resonanzleiter angeordnet ist.

9. Das Drahtlos-IC-Bauelement gemäß einem der Ansprüche 6 bis 8, bei dem der Resonanzleiter (68) derart angeordnet ist, dass ein Mittelabschnitt des Resonanzleiters (68) benachbart zu einem Ort des Hochfrequenzbauelements angeordnet ist.

10. Das Drahtlos-IC-Bauelement gemäß einem der Ansprüche 6 bis 9, bei dem eine Mehrzahl der Hochfrequenzbauelemente vorgesehen ist und der Resonanzleiter (68) mit jedem der Hochfrequenzbauelemente gekoppelt ist.

11. Das Drahtlos-IC-Bauelement gemäß einem der Ansprüche 6 bis 10, bei dem der Resonanzleiter (68) von der Strahlungselektrode trennbar ist.

## Revendications

1. Dispositif de circuit intégré, CI, sans fil, comportant :
un substrat de câblage imprimé (80) ;
une électrode de masse (65, 69) fournie sur le substrat de câblage imprimé (80), dans lequel l'électrode de masse (65, 69) est un film métallique, et l'électrode de masse est configurée de manière à être utilisée en tant qu'une électrode de masse pour un autre circuit ;
un dispositif à haute fréquence incluant une puce CI sans fil (5) et monté sur le substrat de câblage imprimé (80) ; et
une électrode de boucle connectée à la puce CI sans fil (5) ;
dans lequel l'électrode de boucle est définie par au moins l'un(e) parmi une partie de l'électrode de masse (65, 69) ou un élément conducteur (7) qui est différent de l'électrode de masse (65, 69) et est couplé à l'électrode de masse (65, 69) ; et
dans lequel l'électrode de masse (65, 69) définit une électrode de rayonnement qui est configurée de manière à faire rayonner un champ électromagnétique ;
**caractérisé en ce que** :
le dispositif à haute fréquence comporte la puce CI sans fil (5) et un substrat de circuit d'alimentation électrique (4), dans lequel la puce CI sans fil (5) est montée sur le substrat de câblage imprimé (80) par l'intermédiaire du substrat de circuit d'alimentation électrique (4) ;
comportant en outre au moins un circuit résonnant fourni dans le substrat de circuit d'alimentation électrique (4).

2. Dispositif CI sans fil selon la revendication 1, dans lequel
l'électrode de boucle est définie par une partie découpée (66) au niveau d'une arête de l'électrode de masse (65, 69) ; et
le dispositif à haute fréquence est agencé au niveau de la partie découpée (66) et est connecté à l'électrode de masse (65, 69) au niveau de la partie découpée de l'électrode de masse (65, 69).

3. Dispositif CI sans fil selon la revendication 1 ou 2, dans lequel l'électrode de boucle est fournie au niveau d'une partie de montage, au niveau de laquelle le dispositif à haute fréquence est monté, de sorte qu'un plan de boucle de l'électrode de boucle est agencé dans une direction d'un plan de l'électrode de rayonnement.

4. Dispositif CI sans fil selon la revendication 3, comportant en outre :
un circuit d'adaptation (67) fourni entre la partie de montage du dispositif à haute fréquence et l'électrode de boucle, dans lequel
le circuit d'adaptation connecte électriquement directement le dispositif à haute fréquence à l'électrode de boucle.

5. Dispositif CI sans fil selon la revendication 1, dans lequel une fréquence résonnante dudit au moins un circuit résonnant correspond à une fréquence d'un signal échangé par l'électrode de rayonnement.

6. Dispositif CI sans fil selon l'une quelconque des revendications 1 à 5, comportant en outre :
un conducteur résonnant (68) présentant une fréquence résonnante qui est égale à une fréquence de fonctionnement du dispositif à haute fréquence, dans lequel
le conducteur résonnant (68) est couplé au dispositif à haute fréquence.

7. Dispositif CI sans fil selon la revendication 6, dans lequel le conducteur résonnant (68) est agencé parallèlement à une partie d'arête de l'électrode de rayonnement.

8. Dispositif CI sans fil selon la revendication 6 ou 7, dans lequel le conducteur résonnant (68) présente une longueur qui est égale à un côté de l'électrode de rayonnement, lequel est adjacent au conducteur résonnant.

9. Dispositif CI sans fil selon l'une quelconque des revendications 6 à 8, dans lequel le conducteur résonnant (68) est agencé de sorte qu'une partie centrale du conducteur résonnant (68) est adjacente à un emplacement du dispositif à haute fréquence.

10. Dispositif CI sans fil selon l'une quelconque des revendications 6 à 9, dans lequel une pluralité de dispositifs à haute fréquence est fournie, et le conducteur résonnant (68) est couplé à chacun des dispositifs à haute fréquence.

11. Dispositif CI sans fil selon l'une quelconque des revendications 6 à 10, dans lequel le conducteur résonnant (68) est séparable de l'électrode de rayonnement.
